# EUROPEAN PATENT APPLICATION

(11) **EP 2 224 480 A1**
(43) Date of publication of application: **01.09.2010**
(21) Application number: 09153656.5
(22) Date of filing: 25.02.2009
(51) Int. Cl.: H01L 23/367

(54) **The Improved Structure of a Radiator**

(71) Applicant: Chen, Te-Lung, Tainan City 709 (CN)
(72) Inventor: Chen, Te-Lung, Tainan City 709 (CN)
(74) Representative: Lösch, Christoph Ludwig Klaus

(57) **Abstract**

The improved structure of LED radiator comprises a radiator comprising with a better heat-dissipating plate bent by a machine as a plurality of continuously arranged bottom areas (21), side areas (22) and top areas (23). The length of the top areas and the bottom areas is the same. The top and the bottom areas are respectively vertical with the side areas. The length of each side area is longer than each top and bottom area.

## Description

### BACKGROUND OF THE INVENTION

### 1. Field of the invention

The present invention is related with the improved structure of LED radiator, especially for a radiator comprises with a better heat-dissipating plate bended through the machine as plurality of continuously arranged bottom area, side areas and top area. Because of the fast continuously caulking method for forming the radiator, it speeds the production, saves the time for dismantling and lowers the cost. It is very competitive and has economical efficiency.

### 2. Description of the related art

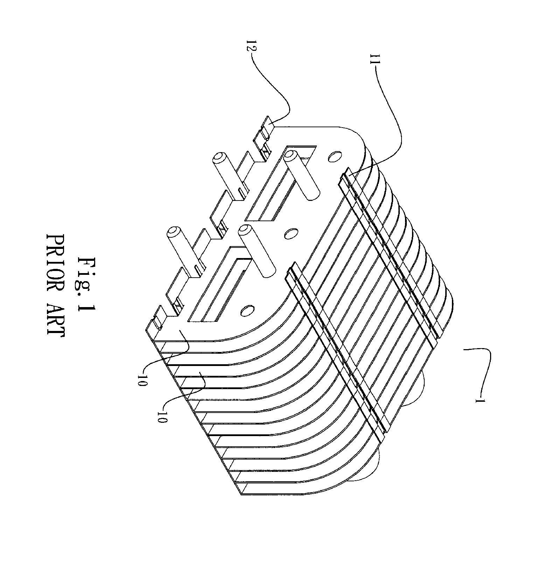

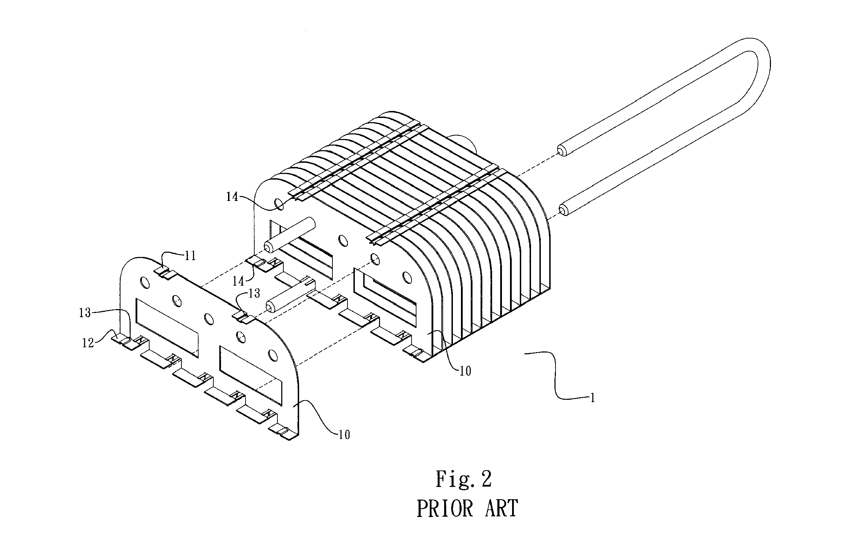

The prior invention as shown in Figs. 1 and 2, the radiator comprises each heat-dissipating chip dismantled one after one by hand. Each top end of the heat-dissipating chip has a top spacer and the bottom end of the heat-dissipating chip has a bottom spacer. A through hole is set on the corner between the top spacer and the heat-dissipating chip and between the bottom spacer and the heat-dissipating chip. When two heat- dissipating chips are composed, the through holes are penetrated through the tenons in front of the top spacer and the bottom spacer to be fixed. The way of comprising the heat-dissipating chips is very popular with radiator inventors nowadays. However, all prior improved structures still have the following shortcomings:
1. Each heat-dissipating chip is composed with through holes which are penetrated through the tenons in front of the top spacer and the bottom spacer. Even so, it needs workers and machines to fix the tenons and the through holes. The tenons are easy to break by the dismantled radiator when bumped with the machine. That will influence the progress of the production and make more imperfect products to decrease the competitiveness.
2. Each radiator comprises with 16 heat-dissipating chips, so there are 16 workers needed for making a radiator. More workers make more cost, especially when there is one mistake in the circulation and will cause the pause during the production. It has no work efficiency at all.
3. The bottom area of the radiator comprises with the bottom spacer of each heat-dissipating chip arranged in order, and it can be adhesive with the aluminum board on LED lights (no figure). The top of the radiator is fixed by the tenons in front of each top spacer penetrating through the through holes. The high heat absorbing from the LED light and the thin design of the tenons will melt and then break the tenons. Therefore, it will lean the top area of all the heat-dissipating chips together and spoil the arrangement for heat dissipating.

### SUMMARY

The present invention is to improve the shortcomings of the prior invention for composing each heat-dissipating chip one after one. The present invention relates to a radiator comprising with a better heat-dissipating plate bended through machine as plurality of continuously arranged bottom area, side areas and top area. The length of the top area and the bottom area is the same. The top and the bottom areas are respectively vertical with the side area. The length of each side area is longer than each top and bottom area.

### BRIEF DESCRIPTION OF THE DRAWINGS

FIG. 1 is a perspective view for the radiator of the prior invention.
FIG. 2 is a schematic drawing illustrating the radiator of the prior invention.
FIG. 3 is a schematic view for the radiator of the present invention.
FIG. 4 is a perspective view for the radiator of the present invention.
FIG. 5 is a side view for the radiator of the present invention.
FIG. 6 is a perspective view for the example of the two-piece radiator of the present invention.
FIG. 7 is a schematic drawing illustrating the example for the two-piece radiator of the present invention.
FIG. 8 is a schematic drawing illustrating the second example for the radiator and the bottom plate.
FIG. 9 is a schematic drawing illustrating the second example for the radiator and the bottom plate.
FIG. 10 is a schematic drawing illustrating the third example for the reverse radiator.
FIG. 11 is a perspective view for the third example of the radiator.
FIG. 12 is a side view for the fourth example of the radiator.

### DETAILED DESCRIPTION OF THE INVENTION

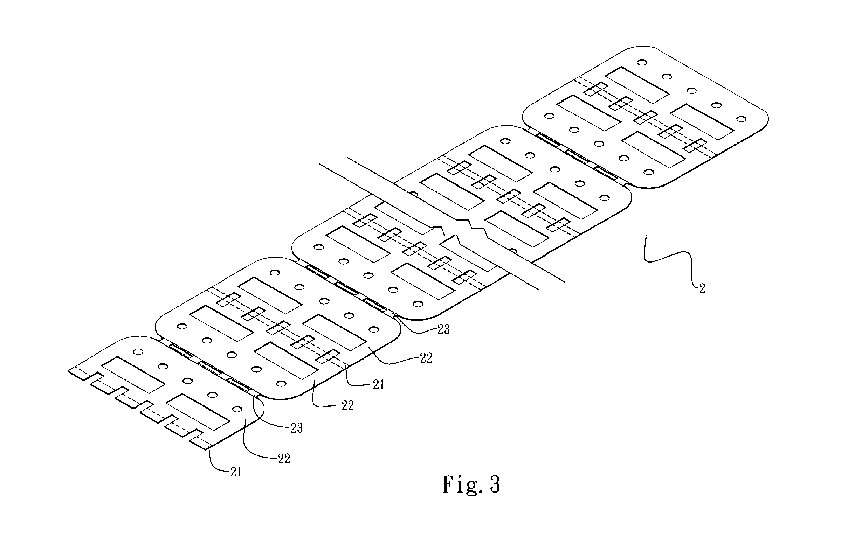

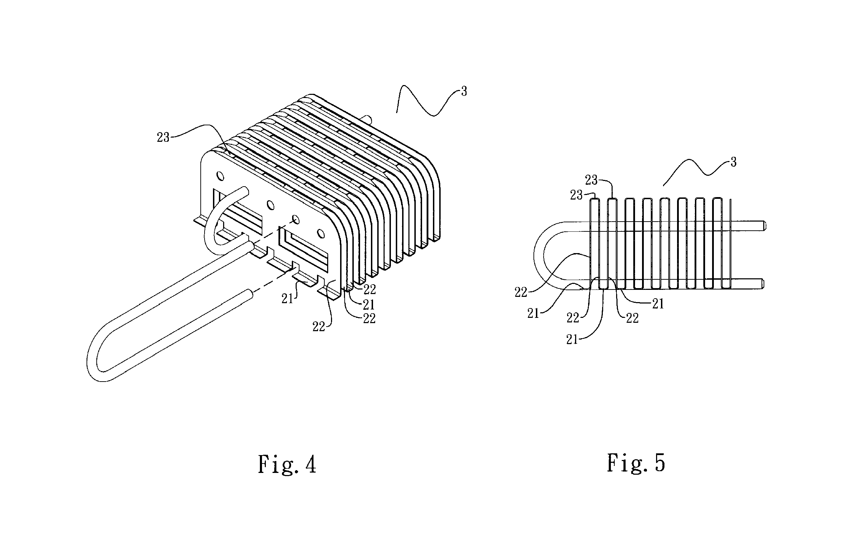

Referring to Figs. 3 through 5, the improved structure of the LED radiator comprises a better heat-dissipating plate (2) . A radiator (3) bended through machine has plurality of bottom area (21), side area (22), top area (23) and side area (22) which arranged continuously in upwardly opening order. The length of the top area (23) and the bottom area (21) on the radiator (3) is the same. The top area (23) and the bottom area (21) are respectively vertical with the side area (22), therefore, there is a space between top and the bottom as shown in Figs. 4 and 5. The length of each side area (22) is the same and is longer than the length of the top area (23) and the bottom area (21).

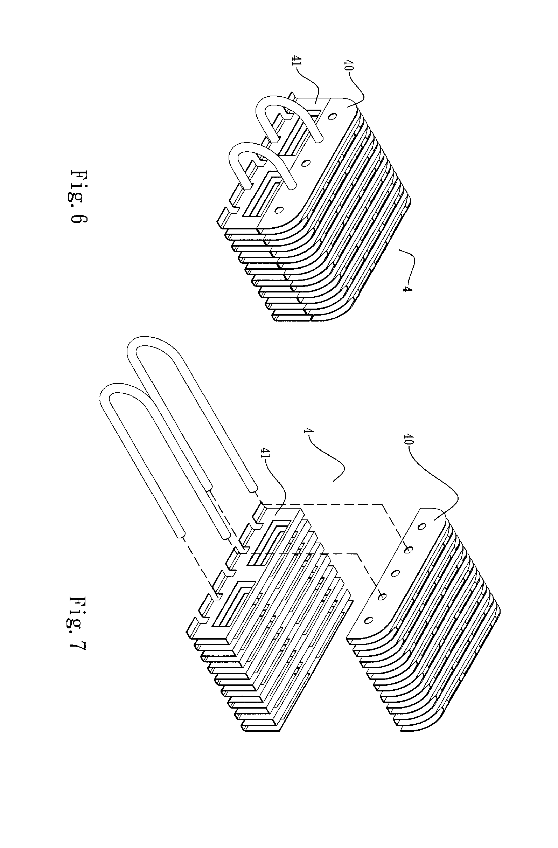

As shown in Figs. 6 and 7, the example of the present invention, the radiator (3) can be adhesive with the top radiator (40) and the bottom radiator (41) to form a two-piece radiator (4) which has the same size as the radiator (3) shown in Fig. 4.

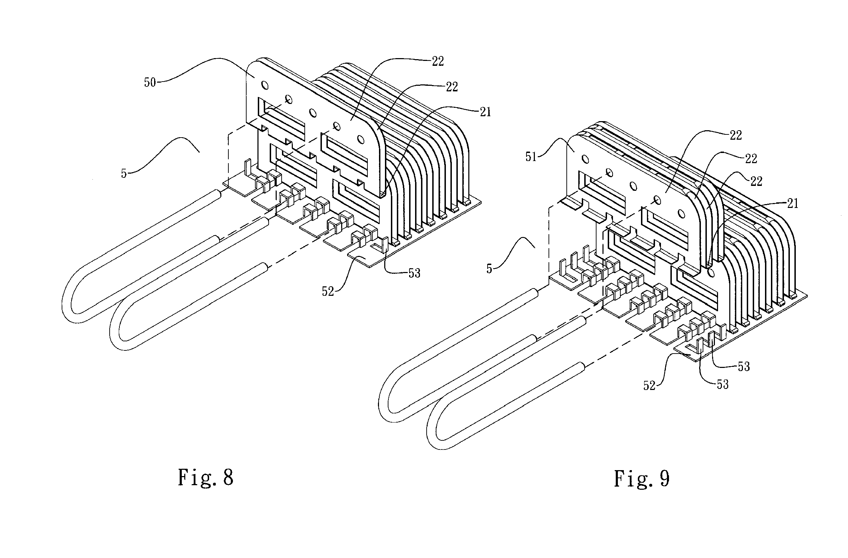

As shown in Figs. 8 and 9, the second example of the present invention, the radiator (5) comprises a bottom plate (52) and two-piece heat-dissipating chips (50) or plurality of heat-dissipating chips (51). After the two-piece heat-dissipating chips (50) and the plurality of heat-dissipating chips (51) are formed through the machine, the two-piece heat-dissipating chips (50) has a bottom area (21) and two side areas (22) vertical with the bottom area (21), and the plurality of heat-dissipating chips (51) has more than two bottom areas (21) and more than two side areas (22). A bottom plate (52) in proper size can be fixed with more two-piece heat-dissipating chips (50) or plurality of heat-dissipating chips (51) thereon to form a radiator (5).

As shown in Figs. 8 and 9, more pairs of corresponding fastened members (53) are set upwardly on the surface of the bottom plate (52). When two-piece heat-dissipating chips (50) or plurality of heat-dissipating chips (51) are set on the bottom plate (52), the fastened members (53) can be bended on the bottom area (21) between two side areas (22) to fix the two-piece heat-dissipating chips (50) or plurality of heat-dissipating chips (51).

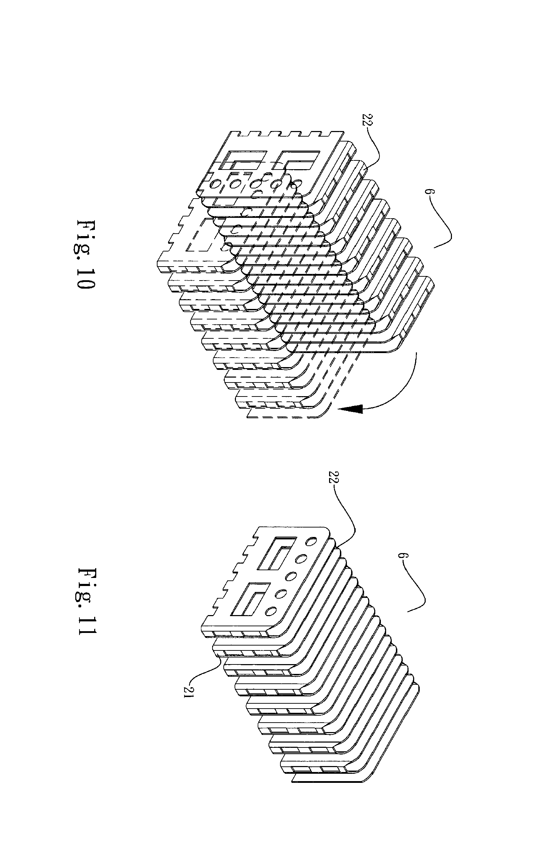

As shown in Figs. 10 and 11 along with Fig. 4, the third example of the present invention, the radiator (3) can be designed as a long-shaped radiator (6). The way to produce the long-shaped radiator (6) and the radiator (3) is the same, but the shape and the size are different. Move the long-shaped radiator (6) shown in Fig. 10 clockwise or counterclockwise to an angle of ninety degree, we will see the long-shaped radiator (6) shown in Fig. 11 is the same as the radiator (3) shown in Fig. 4. The difference is where the bottom area (21) and the top area (23) are in lengthwise position and the side areas (22) are in sidelong position.

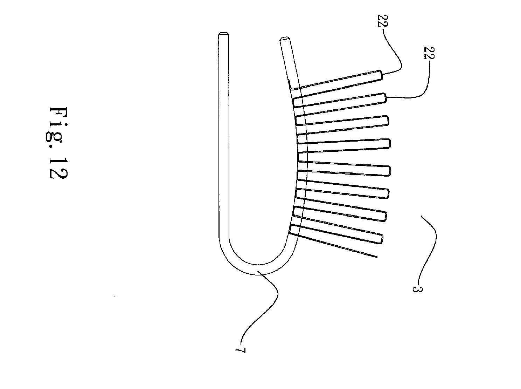

As shown in Fig. 12, the fourth example of the present invention, the bottom of the radiator (3) can be designed as an arc and can be fixed with the curved heat-dissipating pipe (7). Therefore, the side areas (22) will spread radially to larger the space of each side area (22) and to increase the heat dissipating effect.

The present invention mentioned above has the advantages as following:
1. The radiator (3) of the present invention uses a better heat-dissipating plate (2) bended through the machine as plurality of bottom area (21), side areas (22) and top area (23). The molded structure of the radiator (3) not only rids of the work done by hand but also allows for the speed of the production. It may lower the cost and increase the competitiveness.
2. The radiator (3) of the present invention is molded through the machine. It needs no design of the procedures for the circulation, thus it has economic efficiency.
3. The radiator (3) of the present invention is molded through the machine. It prevents the radiator (3) which dissipates the heat coming from the LED lights from melting the whole structure and keeps best heat dissipating effect.

## Claims

1. An improved structure of LED radiator comprising:
a better heat-dissipating plate and;
a bottom area, side area, top area and side area which arranged continuously in upwardly opening order;
the space length of said top area and said bottom area on said radiator is
the same;
said top area and said bottom area are respectively vertical with said side
area, there is a space between each side area;
the length of each side area is the same and said side area is longer than
the length of said top area and said bottom area.

2. An improved structure of LED radiator as recited in claim 1, wherein said radiator can be adhesive with a top radiator and a bottom radiator to form a two-piece radiator.

3. An improved structure of LED radiator as recited in claim 1, wherein said radiator comprises:
a bottom plate and two-piece heat-dissipating chips or plurality of heat-dissipating chips;
said two-piece heat-dissipating chips and said plurality of heat-dissipating chips are formed through the machine, said two-piece heat-dissipating chips have a bottom area and two side areas vertical with said bottom area;
said plurality of heat-dissipating chips have more than two bottom areas and more than two side areas;
a bottom plate in proper size can be fixed with more said two-piece heat-dissipating chips or said plurality of heat-dissipating chips thereon to form said radiator.

4. An improved structure of LED radiator as recited in claim 3 wherein more pairs of corresponding fastened members are set upwardly on the surface of said bottom plate; when said two-piece heat-dissipating chips or said plurality of heat-dissipating chips are set on said bottom plate, said fastened members can be bended on said bottom area between two side areas to fix said two-piece heat-dissipating chips or said plurality of heat-dissipating chips.

5. An improved structure of LED radiator as recited in claim 1, wherein said radiator can be designed as a long-shaped radiator;
the way to produce said long-shaped radiator and said radiator is the same, but the shape and the size are different;
move said long-shaped radiator clockwise or counterclockwise to an angle of ninety degree, said long-shaped radiator is the same as said radiator;
the difference is where said bottom area and said top area are at lengthwise position and said side areas are at the sidelong position.

6. An improved structure of LED radiator as recited in claim 1, wherein the bottom of said radiator can be designed as an arc and can be fixed with a curved heat-dissipating pipe;
said side areas will spread radially to larger the space of each side area and to increase the heat dissipating effect.
